# EUROPEAN PATENT APPLICATION

(11) **EP 4 567 905 A1**
(43) Date of publication of application: **11.06.2025**
(21) Application number: 23850321.3
(22) Date of filing: 25.07.2023
(51) Int. Cl.: H01L 33/14, H01L 33/06, H01L 33/02, H01L 33/62, H01L 33/58, H01L 33/46, H01L 25/075, H01L 27/15

(54) **LIGHT-EMITTING MODULE AND LIGHT-EMITTING SYSTEM COMPRISING SAME**

(30) Priority: 03.08.2022 US 202263394793 P; 14.07.2023 US 202318221963
(71) Applicant: Seoul Viosys Co., Ltd., Ansan-si, Gyeonggi-do 15429 (KR)
(72) Inventor: CHOI, Hyo Shik, Ansan-si, Gyeonggi-do 15429 (KR)
(74) Representative: Stolmár & Partner Patentanwälte PartG mbB
(86) International application number: PCT/KR2023/010757
(87) International publication number: WO 2024/029815

(57) **Abstract**

A light emitting device is disclosed. The light emitting device includes: a first window layer supplying electrons; a second window layer supplying holes; an active layer interposed between the first window layer and the second window layer; an electron regulation layer interposed between the first window layer and the active layer; a hole regulation layer interposed between the second window layer and the active layer; and an intermediate layer interposed between the second window layer and the hole regulation layer, wherein the intermediate layer has different roughnesses on upper and lower interfaces thereof.

## Description

### [Technical Field]

The present invention relates to a light emitting module realizing colors and a light emitting system including the same.

### [Background Art]

A light emitting diode (LED) is one of light emitting devices emitting light upon application of electric current thereto. The light emitting diode is formed by growing epitaxial layers on a substrate and includes an N-type semiconductor layer, a P-type semiconductor layer, and an active layer interposed therebetween. An N-electrode pad is formed on the N-type semiconductor layer and a P-electrode pad is formed on the P-type semiconductor layer, and the light emitting diode is electrically connected to an external power source through the electrode pads and driven. Here, electric current flows from the P-electrode pad to the N-electrode pad through the semiconductor layers.

On the other hand, in order to prevent light loss by the P-electrode pad while improving heat dissipation efficiency, a flip-chip-type light emitting diode is used and various electrode structures are suggested to assist in current spreading in a large-area flip-chip-type light emitting diode. For example, a reflective electrode is formed on the P-type semiconductor layer and extensions for current spreading are formed in an exposed region of the N-type semiconductor layer exposed by etching the P-type semiconductor layer and the active layer.

A display apparatus employing light emitting diodes may be obtained by forming structures of red (R), green (G) and blue (B) light emitting diodes (LEDs) individually grown on a final substrate.

### [Disclosure]

### [Technical Problem]

Embodiments of the present invention provide a light emitting module and a light emitting system including the same. The present invention may be employed as a light source by various devices.

### [Technical Solution]

In accordance with one aspect of the present invention, there is provided a light emitting device including: a first window layer supplying electrons; a second window layer supplying holes; an active layer interposed between the first window layer and the second window layer; an electron regulation layer interposed between the first window layer and the active layer; a hole regulation layer interposed between the second window layer and the active layer; and an intermediate layer interposed between the second window layer and the hole regulation layer, wherein the intermediate layer has different roughnesses on upper and lower interfaces thereof.

The intermediate layer may include an uneven interface.

The intermediate layer may include Al and In and may have a greater In-concentration gradient than an Al-concentration gradient per unit distance.

The intermediate layer may include a Group III material contained in a layer disposed on the intermediate layer and a Group III material contained in a layer disposed under the intermediate layer.

The intermediate layer may have different distributions or densities of Al and In per unit region thereof.

The intermediate layer may have a smaller thickness than a layer disposed on the intermediate layer and a layer disposed under the intermediate layer.

The layer disposed on the intermediate layer, the layer disposed under the intermediate layer, and the intermediate layer may have thicknesses decreasing in the stated sequence.

The intermediate layer may have a continuous shape.

The intermediate layer may have a thickness of greater than 10 nm to 400 nm.

The intermediate layer may have a discontinuous shape.

The intermediate layer may have a thickness of 10 nm or less.

An upper interface of the second window layer may be an uneven surface.

A lower interface of the first window layer may be a textured surface and may have a different shape or roughness than the upper interface of the second window layer.

The light emitting device may further include a first cladding layer interposed between the first window layer and the electron regulation layer.

The light emitting device may further include a second cladding layer interposed between the hole regulation layer and the intermediate layer.

In accordance with another aspect of the present invention, there is provided a light emitting module including the light emitting device; an electrode pad electrically connected to the light emitting device; and a module substrate on which the electrode pad is disposed.

The light emitting module may further include a light reflective layer reflecting at least some fraction of light emitted from the light emitting device.

The light emitting module may include multiple light emitting devices arranged parallel to each other in a horizontal direction.

The light emitting module may include multiple light emitting devices stacked in a vertical direction.

The multiple light emitting devices may have widths gradually increasing in an upward direction.

### [Advantageous Effects]

The present invention includes an intermediate layer to enhance reliability through improvement in lattice match.

### [Description of Drawings]

FIG. 1 is a schematic sectional view of a light emitting device according to a first embodiment of the present invention.
FIG. 2 is a schematic sectional view of a light emitting device according to a second embodiment of the present invention.
FIG. 3 is an image of a portion of a cross-section of a light emitting device according to an embodiment of the present invention.
FIG. 4 is an image obtained by measuring an Al concentration and an In concentration in an uneven interface of an intermediate layer using an atom probe.
FIG. 5 is a graph depicting variation in concentrations of Al and In in an interface region of the intermediate layer.
FIG. 6 is an image of a portion of a cross-section of a light emitting device according to another embodiment of the present invention.
FIG. 7 is an image of a portion of a cross-section of a light emitting device according to a further embodiment of the present invention.
FIG. 8 is a schematic sectional view of a light emitting device according to a third embodiment of the present invention.
FIG. 9 is a schematic sectional view of a light emitting device according to a fourth embodiment of the present invention.
FIG. 10 is a schematic sectional view of a light emitting module according to a first embodiment of the present invention, to which light emitting devices according to the present invention are applied.
FIG. 11 is a schematic cross-sectional view of the light emitting module taken along B-B' in FIG. 10.
FIG. 12 is a schematic sectional view of a light emitting module according to a second embodiment of the present invention, to which light emitting devices according to the present invention are applied.
FIG. 13 is a schematic cross-sectional view of the light emitting module taken along B-B' in FIG. 12.
FIG. 14 is a schematic sectional view of a light emitting module according to a third embodiment of the present invention, to which light emitting devices according to the present invention are applied.
FIG. 15 is a top view of one example of a display panel to which light emitting devices according to yet another embodiment of the present invention are applied.
FIG. 16 is a schematic view of a smart watch, a VR headset, and augmented reality glasses, to which light emitting devices according to the present invention are applied.
FIG. 17 is a schematic view of a vehicle to which light emitting devices according to the present invention are applied.

### [Best Mode]

The present invention may be modified in various ways and may have various forms, and exemplary embodiments will be described in detail with reference to the accompanying drawings. However, it should be understood that the present invention is not limited to particular embodiments disclosed herein and includes all modifications, equivalents and substitutions within the spirit and scope of the present invention.

In addition, it should be noted that the drawings are not to precise scale and some of the dimensions, such as width, length, thickness, and the like, are exaggerated for clarity of description in the drawings. Further, it will be understood that, when an element is referred to as being placed "above" or "on" another element, the element can be placed directly above or on the other element, or intervening element(s) may also be present therebetween. Further, spatially relative terms, such as "under", "above", "left side", "right side", and the like, are used for illustration with reference to the drawings and are not intended to limit the present invention. Herein, a light emitting device according to the present invention may be mounted in an upside down state, as shown in the drawings.

Hereinafter, exemplary embodiment of the present invention will be described in detail with reference to the accompanying drawings.

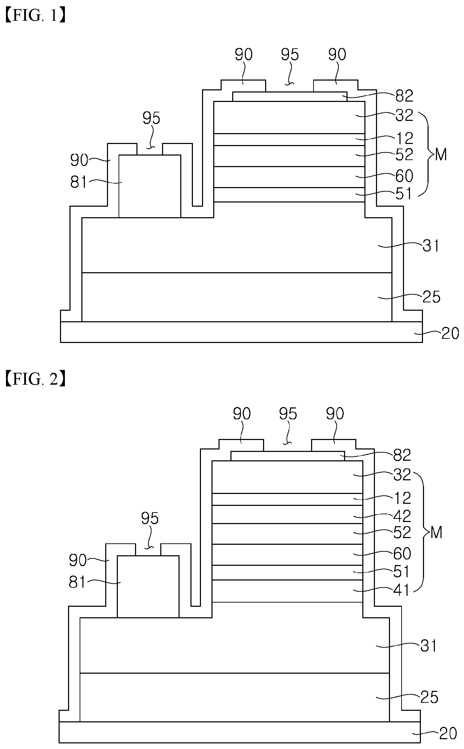

FIG. 1 is a schematic sectional view of a light emitting device according to a first embodiment of the present invention. Referring to FIG. 1, the light emitting device according to the first embodiment includes a first light transmitting layer 20, a second light transmitting layer 25, a first window layer 31, an electron regulation layer 51, an active layer 60, a hole regulation layer 52, an intermediate layer 12, a second window layer 32, a first ohmic layer 81, a second ohmic electrode 82, and an insulating layer 90.

FIG. 2 is a schematic sectional view of a light emitting device according to a second embodiment of the present invention. Referring to FIG. 2, the light emitting device according to the second embodiment further includes a first cladding layer 41 and a second cladding layer 42 in addition to the components of the light emitting device according to the first embodiment.

Hereinafter, the light emitting device according to the present invention will be described in detail with reference to FIG. 1 and FIG. 2.

The first light transmitting layer 20 transmits light emitted from the active layer 60 and may be formed of a light transmissive insulating material. Here, the "light transmissive" material includes not only a transparent material that allows transmission of all light therethrough, but also a translucent or partially transparent material that transmits only light having a certain wavelength, or a fraction of light having a certain wavelength. In the following, the same definition will be applied.

The first light transmitting layer 20 may be a substrate, for example, any one of a sapphire substrate, a silicon substrate and a gallium nitride substrate.

The first light transmitting layer 20 may include a side roughness formed along an outer side surface thereof to improve light spreading efficiency. An outer boundary of the first light transmitting layer 20 may be disposed outside an outer boundary of the light emitting device. Accordingly, since the first light transmitting layer 20 has a larger area than the light emitting device while supporting the light emitting device, the first light transmitting layer 20 can protect the light emitting device from external impact. In addition, the first light transmitting layer 20 may have a greater width than the light emitting device in a longitudinal direction thereof. Accordingly, even when the light emitting device has a broad beam angle, light emitted from the light emitting device can be effectively discharged through the first light transmitting layer 20. One surface of the first light transmitting layer 20 disposed to face the light emitting device may include roughness. This structure increases bonding strength to the light emitting device through increase in surface area of the one surface of the first light transmitting layer 20. However, it should be understood that other implementations are also possible. Alternatively, the one surface of the first light transmitting layer 20 disposed to face the light emitting device may be a flat surface.

The second light transmitting layer 25 is disposed on the first light transmitting layer 20, transmits light emitted from the active layer 60, and may be formed of a light transmissive insulating material. The second light transmitting layer 25 may act as a bonding layer that bonds the first window layer 31 to the first light transmitting layer 20, and may be formed of any material having light transmissive characteristics, such as silicone, polyimide, polypropylene, benzocyclobutene (BCB), silicon dioxide, and the like. The second light transmitting layer 25 may have a different index of refraction than the first window layer 31 and the second light transmitting layer 25, thereby improving light extraction through effective refraction of light at an interface with a different index of refraction.

The second light transmitting layer 25 may include regions having different thicknesses. A thickness t2 of a region of the second light transmitting layer disposed outside the outer boundary of the light emitting device so as not to overlap the light emitting device may be smaller than a thickness t1 of a region of the second light transmitting layer overlapping the light emitting device. Accordingly, the insulating layer 90 covering the light emitting device may extend to the region having the thickness t2. Since the second light transmitting layer 25 includes the regions having different thicknesses, the second light transmitting layer can have an extended surface area, which increases lifespan of the light emitting device through increase in intrusion path of moisture into the light emitting device.

The region of the second light transmitting layer 25 overlapping the light emitting device may include regions having different thicknesses. A portion of the second light transmitting layer 25 may extend towards the light emitting device to include a relatively thick region. Alternatively, a portion of the second light transmitting layer 25 may extend towards the first light transmitting layer 20 to include a relatively thick region. The structure with the regions having different thicknesses can improve a light extraction effect through increase in light scattering.

An outer periphery of the first light transmitting layer 20 may be exposed from the second light transmitting layer 25. In addition, an exposed surface of the first light transmitting layer 20 may be covered by an insulating material. The insulating material covering the first light transmitting layer 20 may be different from a material of the second light transmitting layer 25. The insulating material may be the same as a material of the insulating layer 90, which covers the light emitting device, and may be different from the material of the second light transmitting layer 25. The insulating material may cover a side surface of the second light transmitting layer 25.

The first window layer 31 is disposed on the second light transmitting layer 25 and serves to generate and supply electrons. Dopants for the first window layer 31 may include Si or Te. In addition, an outer boundary of the first window layer 31 may include an inclined side surface.

The first window layer 31 may include a first high-level doping layer. The first high-level doping layer has a higher doping level than other portions of the first window layer 31 and is exposed upon etching of a mesa (M) to electrically contact the first ohmic layer 81. Hereinafter, a portion of the first window layer 31 having a lower doping level than the first high-level doping layer will be referred to as "low-level doping layer".

Since the first window layer 31 includes the first high-level doping layer, it is desirable that the first window layer 31 be formed to a greater thickness than a typical light emitting diode. The thickness of the first window layer 31 may be 50% or more of an entire thickness of the light emitting device. In addition, the thickness of the first window layer 31 may be 80% or more of a thickness from a lower surface of the active layer 60 to an upper surface of the second light transmitting layer 25. By way of example, the entire thickness of the light emitting device may be in the range of 4,500 nm to 7,600 nm, preferably 6,500 nm to 7,600 nm. A portion of the light emitting device under the active layer 60 may have a thickness of 3,000 nm to 5,200 nm and the first window layer 31 may have a thickness of 3,000 nm to 5,000 nm. The first window layer 31 may be an n-type doped InₓGa_{y}Al_{z}P layer. Here, y+z may be set to satisfy a relation: x*0.8≤y+z≤x*1.2. Alternatively, x, y and z may be set to satisfy x+y+z=1. In addition, in InₓGa_{y}Al_{z}P of the first window layer 31, z may be in the range of 0.15≤z≤0.4. With this Al composition, the light emitting device can improve light extraction efficiency by preventing light generated in the light emitting device from being absorbed by the first window layer 31. The first window layer 31 may have an index of refraction in the range of 3.05 to 3.2. The first window layer 31 may have a higher index of refraction than layers disposed on or under the first window layer 31, thereby securing effective light extraction through high index of refraction. The first window layer 31 may have a concentration of 5E17 atoms/cm³ to 5E18 atoms/cm³.

In another embodiment, the first window layer 31 may include the first high-level doping layer and a low-level doping layer having a relatively low doping concentration.

When the first high-level doping layer is formed to contact the first ohmic layer 81, sufficient ohmic contact can occur between the first window layer 31 and the first ohmic layer 81. Accordingly, for electrical bonding to the first ohmic layer 81, the first window layer 31 may be exposed and a mesa M may be formed in a direction from the first window layer 31 to the second window layer 32. Accordingly, the first ohmic layer 81 and the second ohmic electrode 82 may be disposed to face in the same direction, thereby enabling easier circuit connection upon electrical connection of the light emitting device to a circuit.

The thickness of the first high-level doping layer may be about 3% to less than about 30% of the thickness of the first window layer 31, about 5% to less than about 30% of the thickness of a portion of the light emitting device under the active layer 60, and about 30% or less, preferably about 6% to less than about 20%, of the total thickness of the light emitting device. By way of example, when the light emitting device has a total thickness of 7,600 nm, the portion of the light emitting device under the active layer 60 may have a thickness of 5,200 nm, and the first window layer 31 may have a thickness of 4,500 nm, the first high-level doping layer may have a thickness of 300 nm to 900 nm, preferably 400 nm to 600 nm.

In addition, the doping level of the first high-level doping layer may be 10 or less times, preferably 5 times to 10 times, the doping level of the low-level doping layer. By way of example, the low-level doping layer may have an average doping level of about 1E17 to 3E18 (hereinafter, exponential notation is used) atoms/cm³ and the first high-level doping layer may have a doping level of 4E18 atoms/cm³ or more. With such a relation between the doping concentrations, the light emitting device can maintain stable electrical characteristics.

In another embodiment, the first window layer 31 may include a second high-level doping layer on a lower surface thereof (in an opposite direction to the first high-level doping layer. The same hereinafter.), which has a higher doping level than the low-level doping layer.

The second high-level doping layer may be included in a portion of a textured region when a lower surface of the first window layer 31 is subjected to a texturing process. Increase in the doping level of the second high-level doping layer can allow not only efficient texturing on the first window layer 31, but also effective interfacial bonding between a semiconductor layer and the first light transmitting layer 20 due to impurities when the first light transmitting layer 20 is bonded to the semiconductor layer after removal of a growth substrate. In addition, when a bonding material is disposed between the semiconductor layer and the first light transmitting layer 20, interfacial bonding can be effectively achieved.

The present invention includes an embodiment wherein the light emitting device does not include the second high-level doping layer at the final step after texturing on the lower surface of the first window layer 31, and an embodiment wherein the light emitting device includes the second high-level doping layer at the final step after texturing on the lower surface of the first window layer 31.

The second high-level doping layer may have a substantially similar doping level to or a slightly lower doping level than the first high-level doping layer.

The electron regulation layer 51 is disposed on the first window layer 31 and serves to reduce a speed at which electrons reach the active layer 60. The speed at which electrons reach the active layer 60 may be adjusted by adjusting the thickness of the electron regulation layer 51, and the electron regulation layer 51 may be an InₓGa_{y}Al_{z}P layer. Here, y and z may be set to satisfy a relation: x*0.8≤y+z≤x*1.2. Alternatively. x, y and z may be set to satisfy x+y+z=1. In addition, z may be in the range of 0.15≤z≤0.4. With this Al composition, the light emitting device can improve light extraction efficiency by preventing light generated in the light emitting device from being absorbed by the electron regulation layer 51.

The active layer 60 is disposed on the electron regulation layer 51 and may be a multi-quantum well (MQW) layer, in which quantum well (QW) layers and quantum barrier (QB) layers are alternately stacked one above another, and in which light is generated through recombination of electrons and holes. The active layer 60 may have a thickness of 550 nm to 650 nm.

The quantum well layers and the quantum barrier layers have different energy band-gaps, and each of the quantum well layers may have any one composition among AlInGaP and InGaP and may have a thickness of 3 nm to 7 nm. Each of the barrier layers may be formed of InₓGa_{y}Al_{z}P. Here, y and z may be set to satisfy a relation: x*0.8≤y+z≤x*1.2. Alternatively, x, y and z may be set to satisfy x+y+z=1. In addition, z may be in the range of 0.15≤z≤0.4. In addition, after growth of an InGaP layer as the quantum well layers, the quantum barrier layers may be formed by growing an InAlGaP layer having an Al content of about 40% as a capping layer, followed by growing a main InAlGaP layer having an Al content of about 50% to about 90%.

Each of the quantum well layers may have a thickness of 3 nm to 7 nm, each of the quantum barrier layers may have a thickness of 20 nm or less, and the active layer 60 may have a thickness of 100 nm to 650 nm. The number of quantum well layer/quantum barrier layer pairs may be in the range of 10 to 40.

The hole regulation layer 52 is disposed on the active layer 60 and serves to reduce a speed at which holes reach the active layer 60. The speed at which the holes reaches the active layer 60 may be adjusted by adjusting the thickness of the hole regulation layer 52. The hole regulation layer 52 may include three types of Group III elements. The hole regulation layer 52 may include the same Group III and V elements as the electron regulation layer 51 and may be an InₓGa_{y}Al_{z}P layer. Here, y and z may be set to satisfy a relation: x*0.8≤y+z≤x*1.2. Alternatively, x, y and z may be set to satisfy x+y+z=1. In addition, z may be in the range of 0. 15≤z≤0.4. The thickness of the hole regulation layer 52 may be set to 50 nm or more and the hole regulation layer 52 can effectively prevent p-type dopants or carbon from diffusing into the active layer while improving reliability and characteristics of low-current voltage and reverse-voltage current.

The intermediate layer 12 may be disposed between the second window layer 32 described below and the hole regulation layer 52 in the first embodiment, and may be disposed between the second window layer 32 and the second cladding layer 42 in the second embodiment. The intermediate layer 12 serves to improve reliability through improvement in lattice match between a layer disposed on the intermediate layer 12 and a layer disposed under the intermediate layer 12.

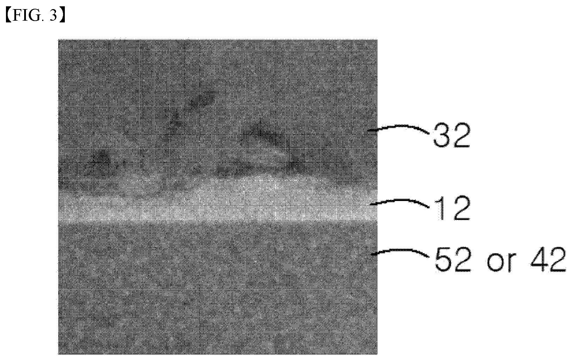

FIG. 3 is an image of a portion of a cross-section of a light emitting device according to an embodiment of the present invention. Referring to FIG. 3, the intermediate layer 12 may include an uneven interface. That is, the intermediate layer 12 may include an interface having regions with different thicknesses.

Upper and lower interfaces of the intermediate layer 12 may have different roughnesses and may have different surface areas.

Although FIG. 3 shows the intermediate layer 12 having a relatively even upper interface and a relatively uneven lower interface, the light emitting device according to the present invention may include a structure wherein the upper and lower interfaces of the intermediate layer 12 are even, a structure wherein the upper interface of the intermediate layer 12 is even whereas the lower interface of the intermediate layer 12 is uneven, and a structure wherein the upper and lower interfaces of the intermediate layer 12 are uneven.

The intermediate layer 12 including an uneven interface has a large surface area, thereby providing an effect of relieving stress at the interface thereof.

The intermediate layer 12 includes Group III materials (B, Al, Ga, In, Tl, Nh), which are contained in the layer disposed on the intermediate layer 12, and Group III materials, which are contained in the layer disposed under the intermediate layer 12. By way of example, when the layer disposed on the intermediate layer 12 is a GaP layer and the layer disposed under the intermediate layer 12 is an InAlP layer, the intermediate layer 12 may be an InAlGaP layer.

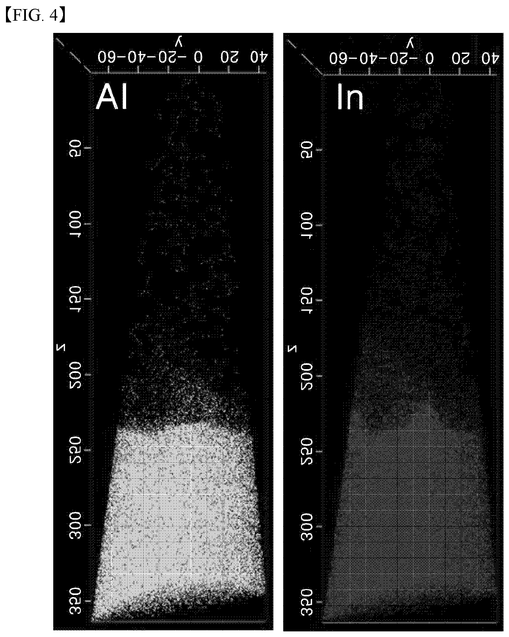

FIG. 4 is an image obtained by measuring the concentrations of Al and In in an uneven interface of the intermediate layer using an atom probe.

Referring to FIG. 4, for the intermediate layer 12 containing Al and In, upon analysis of the uneven interface of the intermediate layer 12 through measurement of the concentrations of Al and In in the intermediate layer 12 using an atom probe, it can be seen that the uneven interface includes at least two points having different concentrations of Al or In. Alternatively, the intermediate layer 12 may have different Al and In distributions and different Al and In densities per unit region thereof.

Further, for the intermediate layer 12 containing Al and In**,** upon analysis of the uneven interface of the intermediate layer 12 using the atom probe, the shape of an interface in an image obtained by measuring the concentration of In may be different from the shape of an interface in an image obtained by measuring the concentration of Al. Alternatively, the shape of the interface in the image obtained by measuring the concentration of In may be more uneven than the shape of the interface in the image obtained by measuring the concentration of Al.

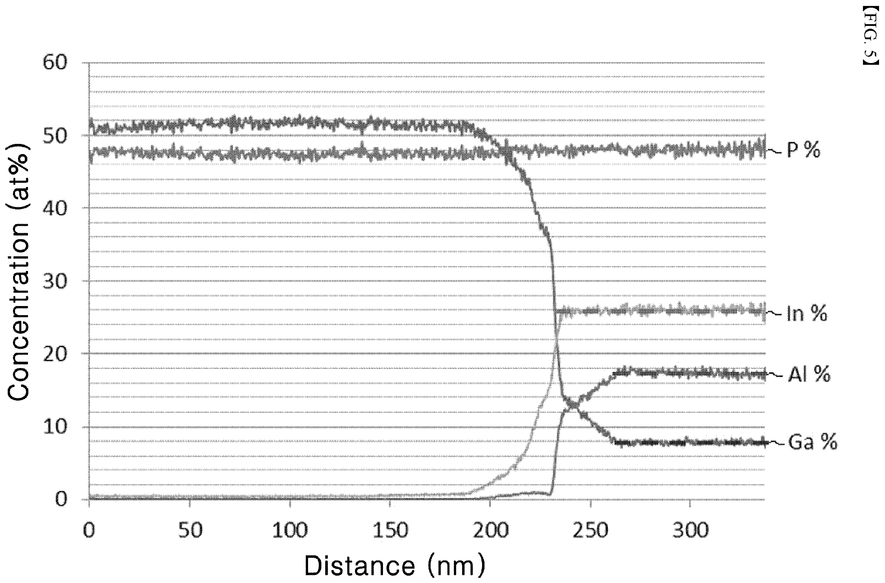

FIG. 5 is a graph depicting variation in concentrations of Al and In in an interface region of the intermediate layer. Referring to FIG. 5, a portion of the interfacial region of the intermediate layer 12 may have different gradients between the concentration of In and the concentration of Al. Alternatively, the intermediate layer 12 may include a region in which the In-concentration gradient is greater than the Al-concentration gradient in terms of unit distance (that is, the concentration of In can be more steeply changed than the concentration of Al).

For the intermediate layer 12 containing Al and In**,** a point at which the concentration of In starts to increase in the uneven interface of the intermediate layer 12 may be different from a point at which the concentration of Al starts to increase in the uneven interface of the intermediate layer 12. According to the present invention, the increase start point of the concentration of In is set to be different from the increase start point of the concentration of Al in consideration of the fact that In is more sensitive to temperature than Al.

The intermediate layer 12 may have a smaller thickness than the layer on the intermediate layer 12 and the layer under the intermediate layer 12, and may have a thickness of less than 50% of the thickness of the layer under the intermediate layer 12.

In addition, the layer disposed on the intermediate layer 12, the layer disposed under the intermediate layer 12, and the intermediate layer 12 may have thicknesses decreasing in the stated sequence. That is, among the layer disposed on the intermediate layer 12, the layer disposed under the intermediate layer 12, and the intermediate layer 12, the layer closest to the second ohmic electrode 82 may have the largest thickness, the layer close to the active layer 60 may have the second largest thickness, and the layer interposed between these layers may have the smallest thickness.

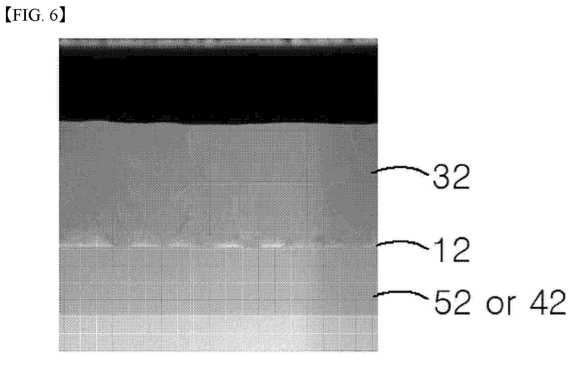

Unlike the intermediate layer 12 of the second embodiment shown in FIG. 6, the intermediate layer 12 of the first embodiment shown in FIG. 3 may have a continuous shape without any broken portion per unit region and may have a thickness of greater than 10 nm to 400 nm.

FIG. 6 is an image of a portion of a cross-section of a light emitting device according to another embodiment of the present invention. Referring to FIG. 6, the intermediate layer 12 according to the second embodiment may have a discontinuous shape per unit region and may have a thickness of 10 nm or less.

The intermediate layer 12 according to the second embodiment includes multiple regions spaced apart from each other and each embedded (isolated) in the layer disposed on the intermediate layer 12 and the layer disposed under the intermediate layer 12. A side surface of the intermediate layer 12 may be covered by the layer disposed on the intermediate layer 12.

In the discontinuous shape of the intermediate layer 12 according to the second embodiment, direct contact between the layer disposed on the intermediate layer 12 and the layer disposed under the intermediate layer 12 occurs at a broken portion of the intermediate layer 12.

The discontinuous shape of the intermediate layer 12 according to the second embodiment allows effective diffusion of electric current at the broken portion of the intermediate layer 12.

The second window layer 32 is disposed on the intermediate layer 12 and serves to generate and supply holes. In addition, the second window layer 32 may be a GaP layer and may contain Mg or C, or both Mg and C as dopants. The second window layer 32 may have a doping level of 7E17 to 4E18 atoms/cm³. The second window layer 32 may have a thickness of 400 nm to 10,000 nm, preferably about 1,000 nm. The second window layer 32 may include at least one type of Group III element.

The second window layer 32 may be grown at a growth temperature of about 500°C to 750°C. Preferably, in order to secure quality of the second window layer 32, the second window layer 32 is grown at a temperature which is at least 20° higher than the growth temperature of the active layer 60. By way of example, the growth temperature of the active layer 60 may be about 680°C and the growth temperature of the second window layer 32 may be about 700°C.

To secure effective ohmic contact with the second ohmic electrode 82, the second window layer 32 may have a contact region having a high doping level at an upper portion thereof contacting the second ohmic electrode 82. By way of example, the contact region may have a doping level of 7E17 to 1E19 atoms/cm³. Excluding the contact region, the second window layer 32 may have an average doping level of about 1E18 atoms/cm³. The contact region may be grown at a growth temperature of about 600°C or more and may be a GaP layer. Since a high concentration of dopants in a semiconductor layer can provide defects in the semiconductor layer, thickness increase can cause deterioration in luminous efficacy through absorption of light due to such defects. Accordingly, the contact region may have a thickness of less than 100 nm.

On the other hand, the second window layer 32 according to the present invention may have an uneven upper interface. The uneven upper interface of the second window layer 32 increases a contact area between the second window layer 32 and the second ohmic electrode 82, thereby improving electrical stability.

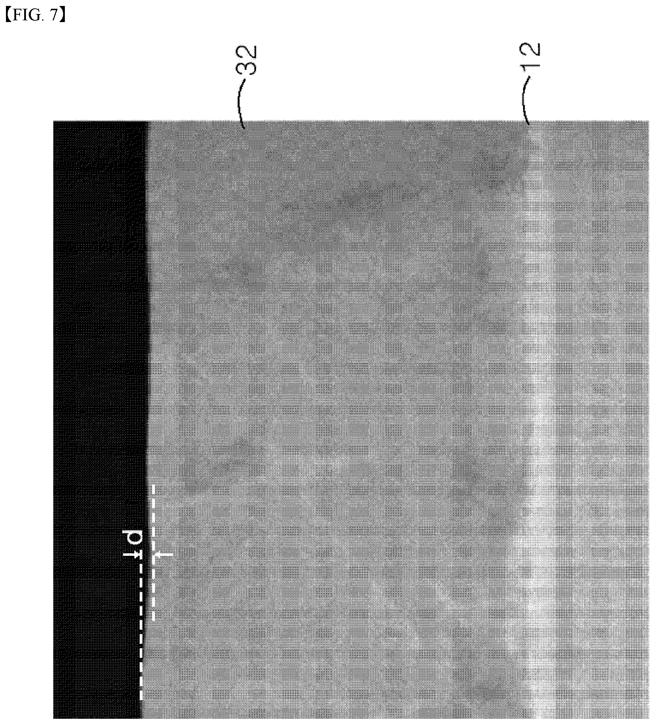

FIG. 7 is an image of a portion of a cross-section of a light emitting device according to a further embodiment of the present invention. Referring to FIG. 7, a thickness difference d between the uppermost point and the lowermost point of the upper interface of the second window layer 32 may be about 10 nm.

The first ohmic layer 81 may be electrically connected to the first window layer 31 to form ohmic contact therewith and may be formed of a metallic material. The first ohmic layer 81 contacts the high-level doping layer of the first window layer 31 to form ohmic contact therewith. The first ohmic layer 81 may be a light reflective material or a light transmissive material. The light reflective material may include at least one of materials, such as Ge, Al, Cu, Ag, Au, Ni, Cr, Ti, Pt, Rd, Ru, W, Mo, TiW, and the like, which have reflective characteristics with respect to at least some fractions of light, and the light transmissive material may include at least one of materials, such as ITO, ZnO, and the like, which have transmissive characteristics with respect to at least some fractions of light.

The second ohmic electrode 82 is disposed on the second window layer 32 to form ohmic contact therewith through electrical connection to the second window layer 32 and may be formed of a metallic material. The second ohmic electrode 82 may be a light reflective material or a light transmissive material. The light reflective material may include at least one of materials, such as Ge, Al, Cu, Ag, Au, Ni, Cr, Ti, Pt, Rd, Ru, W, Mo, TiW, and the like, which have reflective characteristics with respect to at least some fractions of light, and the light transmissive material may include at least one of materials, such as ITO, ZnO, and the like, which have transmissive characteristics with respect to at least some fractions of light.

The insulating layer 90 may cover most of the exposed surface of the light emitting device and may contain SiO₂. The insulating layer 90 may be a light transmissive material or a material exhibiting characteristics of an oxide layer. For example, the insulating layer 90 may be formed of a material, such as SiO₂, TiO₂, AlOₓ, NiOₓ, and the like. The insulating layer 90 may exhibit reflectivity with respect to light generated from the active layer 60 and may include a distributed Bragg reflector.

The insulating layer 90 on an upper surface of each of the first ohmic layer 81 and the second ohmic electrode 82 may be formed with an opening 95.

Referring to FIG. 2, the first cladding layer 41 may be disposed between the first window layer 31 and the electron regulation layer 51. The first cladding layer 41 may have a relatively high energy band-gap to act as a barrier layer that blocks holes from entering the first window layer 31.

The first cladding layer 41 may be doped with a different type of dopant from the first window layer 31, and may use dopants having a larger atomic size than the dopants of the first window layer 31.

As the dopants of the first cladding layer 41, Si, B, P, As, Sb or Te may be used. Here, since Te has a larger atomic size than Si, Te can provide higher breakdown voltage (VR) and better brightness characteristics, and can more efficiently form an n-type layer even at a lower concentration than Si, when used as the dopants of the first cladding layer. However, it should be understood that the present invention is not limited thereto and the first cladding layer 41 may include the same kind of dopant as the first window layer 31.

The first cladding layer 41 may be an n-InₓAl₍₁₋ₓ₎P layer, where x is in the range of 0.4≤x≤0.6. The first cladding layer 41 may have a thickness of less than 200 nm, preferably 200 nm to 450 nm. The first cladding layer 41 may have a doping level of 5E17 to 3E18 atoms/cm³. The first cladding layer 41 may have a higher doping concentration than the electron regulation layer 51.

The first window layer 31 and the electron regulation layer 51 may be formed of the same type of Group III element and the first cladding layer 41 may have a composition that is free of one of Group III elements in the composition of the first window layer 31.

By way of example, the first window layer 31 may have a composition of four types of atoms, in which three types of atoms may be Group III elements (B, Al, Ga, In, Tl, Nh, hereinafter the same) and the other type of atom may be an element having a standard atomic weight of 30 or more. The first cladding layer 41 may have a composition of three types of atoms, in which two types of atoms may be Group III elements and the other type of atom may be an element having a standard atomic weight of 30 or more.

By way of example, the first window layer 31 and the electron regulation layer 51 may be n-InₓGa_{y}Al_{z}P layers or u-InₓGa_{y}Al_{z}P layers, and the first cladding layer 41 may be an n-InₓAl₍₁₋ₓ₎P layer.

In addition, two types of Group III elements of the first cladding layer 41 may be the same as an element having the largest atomic weight and an element having the smallest atomic weight among the three types of Group III elements of the first window layer 31, in which the element having a standard atomic weight of 30 or more in the first cladding layer 41 may be the same as the element having a standard atomic weight of 30 or more in the first window layer 31. By way of example, the first cladding layer 41 may be an n-InₓAl₍₁₋ₓ₎P layer.

The second cladding layer 42 may be disposed between the hole regulation layer 52 and the intermediate layer 12, and may have a relatively high energy band-gap to act as a barrier layer that blocks electrons from entering the second window layer 32.

The second cladding layer 42 may have a thickness of 500 nm or less, preferably about 300 nm to 500 nm. The second cladding layer 42 may have a doping level of 1E17 to 1E18 atoms/cm³, and may include Mg or C or both Mg and C as dopants. In addition, the second cladding layer 42 may be a p-InₓAl₍₁₋ₓ₎P layer, where x is in the range of 0.4≤x≤0.6. The second cladding layer 42 may be formed of two types of Group III elements and may have a greater energy band-gap than layers disposed at upper and lower sides of the second cladding layer 42. Alternatively, the second cladding layer 42 may have the highest band-gap energy among the semiconductor layers constituting the light emitting device. The second cladding layer 42 may have a lower index of refraction than the layers disposed at the upper and lower sides of the second cladding layer 42. Alternatively, the second cladding layer 42 may have the lowest index of refraction among the semiconductor layers constituting the light emitting device. With the second cladding layer having a low index of refraction, the light emitting device can improve light extraction.

The second cladding layer 42 may have a higher doping concentration than the hole regulation layer 52 disposed under the second cladding layer. Here, the hole regulation layer 52 may not contain a doping material.

Furthermore, in order to protect the active layer from inter-diffusion occurring upon doping of the second cladding layer 42, the hole regulation layer 52 is preferably thicker than the electron regulation layer 51. By way of example, when the electron regulation layer 51 has a thickness of about 150 nm to 350 nm, the hole regulation layer 52 may have a thickness of about 300 nm to 900 nm. Alternatively, the thickness of the hole regulation layer 52 may be 1 to 3 times of the thickness of the electron regulation layer 51. With this structure, the light emitting device can secure balance of a migration speed between electrons and holes.

The light emitting device may further include a light guide layer between the second window layer 32 and the active layer 60 and/or between the active layer 60 and the first window layer 31.

When the light emitting device according to this embodiment includes the second cladding layer 42 and the first cladding layer 41, the light guide layer may be formed between the second window layer 32 and the second cladding layer 42 and/or between the first cladding layer 41 and the first window layer 31.

The light guide layer serves to improve luminous efficacy of the light emitting device through improvement in reflectivity with respect to light emitted from the active layer 60 and may be an InₐAl₍₁₋ₐ₎P layer or an InₓGa_{y}Al_{z}P layer. Here, a may be in the range of 0.4≤a≤0.6, and y and z may be set to satisfy a relation: x*0.8≤y+z≤x*1.2. Alternatively, x, y and z may be set to satisfy a relation: x+y+z=1. In addition, z may be in the range of 0.15≤z≤0.4. These two layers may be formed in the form of a stack of layers having different band-gaps or a stack of multiple pairs of layers having different band-gaps. The n-InₐAl₍₁₋ₐ₎P layer may have an index of refraction of 2.9 to 3.0 and the InₓGa_{y}Al_{z}P layer may have an index of refraction of 3.05 to 3.2. With the two layers having a difference of 0.05 to 0.3 in index of refraction and disposed inside the semiconductor layer, the light emitting device can guide light emitted from the active layer 60 in a desired extraction direction, thereby improving light extraction efficiency.

The light guide layer may be disposed between the active layer 60 and the first window layer 31. Accordingly, the light guide layer can change the path of light, which is emitted from the active layer 60 and travels towards the first window layer 31, so as to travel in a direction from the first window layer 31 towards the second window layer 32, thereby improving light extraction efficiency. Here, at least one layer in the light guide layer may be doped with n-type dopants to provide a structure composed of two layers having different doping concentrations. Alternatively, the light guide layer may have a structure composed of two layers doped with n-type dopants to have different doping concentrations. Alternatively, the light guide layer may have a structure composed of two layers doped with n-type dopants to have the same doping concentration. As the light guide layer includes the n-type layers, the light guide layer can guide light while allowing efficient migration of electrons.

In another embodiment, the light guide layer may be disposed between the active layer 60 and the second window layer 32. The light guide layer may change the path of light, which is emitted from the active layer and travels towards the second window layer 32, so as to travel in a direction from the second window layer 32 towards the first window layer 31, thereby improving light extraction efficiency. Here, at least one layer in the light guide layer may be doped with p-type dopants to provide a structure composed of two layers having different doping concentrations. Alternatively, the light guide layer may have a structure composed of two layers doped with p-type dopants to have different doping concentrations. Alternatively, the light guide layer may have a structure composed of two layers doped with p-type dopants to have the same doping concentration. As the light guide layer includes the p-type layers, the light guide layer can guide light while allowing efficient migration of holes.

In this embodiment, the first window layer 31, the first cladding layer 41 and the first ohmic layer 81 are first conductivity type layers, and the second window layer 32, the second cladding layer 42 and the second ohmic electrode 82 are second conductivity type layers. The first conductivity type and the second conductivity type have opposite polarities. For example, when the first conductivity type is n-type, the second conductivity type is p-type, and when the first conductivity type is p-type, the second conductivity type is n-type.

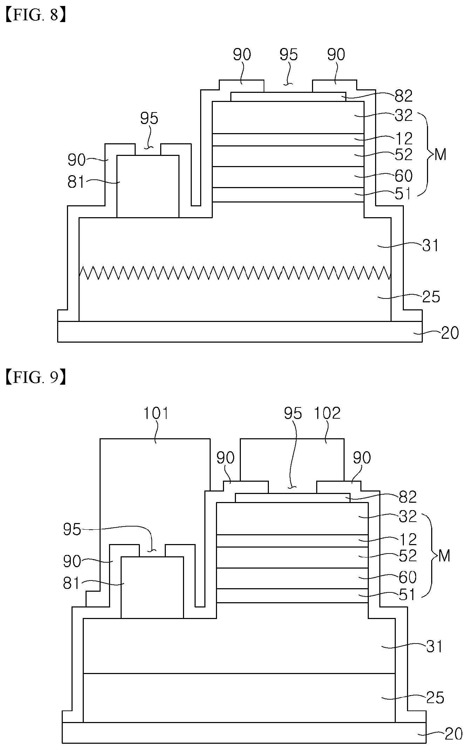

FIG. 8 is a schematic sectional view of a light emitting device according to a third embodiment of the present invention. Referring to FIG. 8, the light emitting device according to the third embodiment is different from the light emitting device according to the first embodiment in that the lower surface of the first window layer 31 is subjected to texturing.

In the light emitting device according to the third embodiment, the lower surface of the first window layer 31 is subjected to texturing, thereby improving luminous efficacy of the light emitting device.

According to this embodiment, the upper interface of the second window layer 32 may be unevenly formed and upper and lower interfaces of the first window layer 31 according to this embodiment may have different shapes and different roughnesses. Accordingly, with different roughness, the first window layer can improve light extraction efficiency by preventing light from remaining therein. Description of the same configuration as the first embodiment will be omitted herein.

FIG. 9 is a schematic sectional view of a light emitting device according to a fourth embodiment of the present invention. Referring to FIG. 9, the light emitting device according to the fourth embodiment is different from the light emitting device according to the first embodiment and further includes a first bump 101 and a second bump 102.

The first ohmic layer 81 is electrically connected to the first bump 101 through the opening 95 formed in the insulating layer 90 on the upper surface of the first ohmic layer 81, and the second ohmic electrode 82 is electrically connected to the second bump 102 through the opening 95 formed in the insulating layer 90 on the upper surface of the second ohmic electrode 82. The first bump 101 and the second bump 102 may be formed of an electrically conductive material, such as Ge, Al, Cu, Ag, Au, Ni, Cr, Ti, Pt, Rd, Ru, W, Mo, TiW, and the like.

A periphery of the second bump 102 formed on the upper surface of the second ohmic electrode 82 may be placed inside a periphery of the insulating layer 90. In addition, the second bump 102 may have the same width as or a narrower width than the second ohmic electrode 82.

A periphery of the first bump 101 formed on the upper surface of the first ohmic layer 81 may extend beyond the periphery of the insulating layer 90 to the upper surface of the first window layer 31. In addition, the first bump 101 may have a greater width than the first ohmic layer 81.

Description of the same configuration as the first embodiment will be omitted herein.

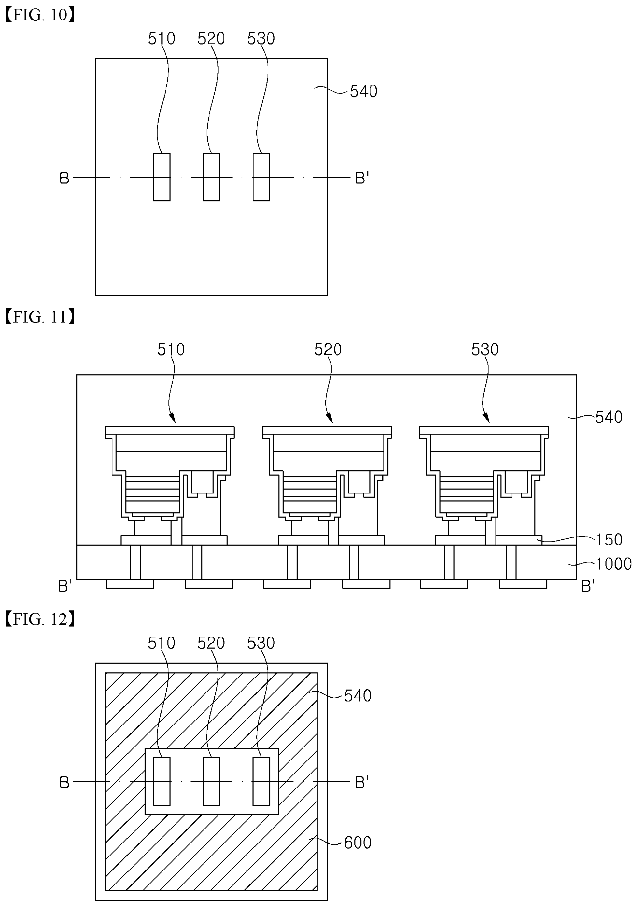

FIG. 10 is a schematic sectional view of a light emitting module according to a first embodiment of the present invention, to which light emitting devices according to the present invention are applied, and FIG. 11 is a schematic cross-sectional view of the light emitting module taken along B-B' in FIG. 10.

Referring to FIG. 10, the light emitting module includes multiple light emitting devices 510, 520, 530, for example, three light emitting devices 510, 520, 530 arranged parallel to each other, in some region on the first light transmitting layer 20. Each of the light emitting devices 510, 520, 530 may be any one of the light emitting devices according to the first to fourth embodiments of the present invention.

A first light emitting device 510 may emit red series light, a second light emitting device 520 may emit green series light, and a third light emitting device 530 may emit blue series light. In another embodiment, the first light emitting device 510 may emit red series light, the second light emitting device 520 may emit yellow series light, and the third light emitting device 530 may emit cyan series light. In a further embodiment, all of the first to third light emitting devices 510, 520, 530 may emit red series light.

A molding portion 540 may be formed on an upper surface of the first light transmitting layer 20 to cover the light emitting devices 510, 520, 530. The first light transmitting layer 20 may be a substrate and may be, for example, any one of a sapphire substrate, a silicon substrate and a gallium nitride substrate. However, the first light transmitting layer 20 may be removed and semiconductor layers of the light emitting devices 510, 520, 530 may contact the molding portion 540. An upper surface of each of the light emitting devices 510, 520, 530 may include a roughness portion and the molding portion 540 may cover upper and side surfaces of the light emitting devices 510, 520, 530 while filling the roughness portion. The roughness portions of the light emitting devices 510, 520, 530 may have different shapes.

Referring to FIG. 11, the light emitting module according to the first embodiment may include a module substrate 1000, which includes multiple electrode pads 150 electrically connected to multiple bumps 101, 102, respectively. The light emitting module according to this embodiment allows multiple times of current injection (by way of example, 3 times of current injection upon connection of three bumps having the same electrical polarity) by an existing driver through multiple electrical connection, thereby realizing a display with high luminance.

Since the light emitting device emitting red series light includes the mesa (M) formed in the same direction as the light emitting devices emitting other colors, the light emitting module according to this embodiment allows easy circuit constitution. Each of the light emitting devices 510, 520, 530 may be electrically connected to the electrode pad 150 such that the active layer of each of the light emitting devices 510, 520, 530 emits light having a predetermined wavelength. Each of the light emitting devices 510, 520, 530 may be individually controlled to emit light.

In one embodiment, a difference in peak wavelength of light emitted from the light emitting devices 510, 520, 530 may be 5 nm or less and the active layers of the light emitting devices 510, 520, 530 may contain the same type of elements. Alternatively, the light emitting devices 510, 520, 530 may contain the same type of Group V element. Accordingly, since multiple light emitting devices exhibiting similar electrical and optical characteristics may be grouped together in a single unit, the light emitting devices can be more easily arrayed in a module. The semiconductor layers constituting each of the light emitting devices 510, 520, 530 may include a first-type semiconductor layer and a second-type semiconductor layer, and a first-type dopant material of each of the light emitting devices 510, 520, 530 may include the same material or a second-type dopant material of each of the light emitting devices 510, 520, 530 may include the same material. The multiple first-type semiconductor layers may be arranged in the same direction with reference to the active layer. In addition, the multiple first-type semiconductor layers may be spaced apart from each other and a difference in thickness therebetween may be 30% or less. Alternatively, the multiple second-type semiconductor layers may be arranged in the same direction with reference to the active layer. In addition, the multiple second-type semiconductor layers may be spaced apart from each other and a difference in thickness therebetween may be 30% or less. With this structure, the light emitting module can reduce luminosity difference due to thickness deviation of the semiconductor layers. Alternatively, the light emitting devices 510, 520, 530 may be disposed to have the same direction in which electrons are supplied to the active layer. Alternatively, the light emitting devices 510, 520, 530 may be disposed to have the same direction in which holes are supplied to the active layer. As a result, the light emitting module can prevent interference of electric fields or magnetic fields between the light emitting devices spaced apart from each other.

In one embodiment, a difference between at least two peak wavelengths of light emitted from the light emitting devices 510, 520, 530 may be 10 nm or more. In addition, the semiconductor layers of at least one of the multiple light emitting devices 510, 520, 530 may be constituted by different types of Group V elements. Alternatively, the semiconductor layers of at least one of the multiple light emitting devices 510, 520, 530 may be constituted by Group V elements having a standard atomic weight of 30 or more. Alternatively, the semiconductor layers of at least one of the multiple light emitting devices 510, 520, 530 may be constituted by Group V elements having different sizes. The semiconductor layers constituting each of the light emitting devices 510, 520, 530 may include a first-type semiconductor layer and a second-type semiconductor layer. Here, the multiple first-type semiconductor layers may be spaced apart from each other and may be arranged in the same direction with reference to the active layer. Alternatively, the multiple second-type semiconductor layers may be spaced apart from each other and may be arranged in the same direction with reference to the active layer. Accordingly, the light emitting devices constituting one light emitting module or one pixel may be arranged to have the same direction of polarity so as to minimize a difference in height from the active layer of each of the light emitting devices 510, 520, 530 to a light emitting surface of the molding portion 540.

In one embodiment, the light emitting devices 510, 520, 530 may have different emission peak wavelengths. Alternatively, the light emitting devices 510, 520, 530 may further include substrates that support the light emitting devices 510, 520, 530, respectively. The substrates may be formed of the same material. That is, at least one of the light emitting devices 510, 520, 530 may contain a different type of Group V material or may have a different peak wavelength than the other light emitting devices, and the substrates respectively supporting the light emitting devices 510, 520, 530 may be formed of the same material, thereby reducing deviation in visibility depending upon the kind of substrate even when light is emitted through the substrate.

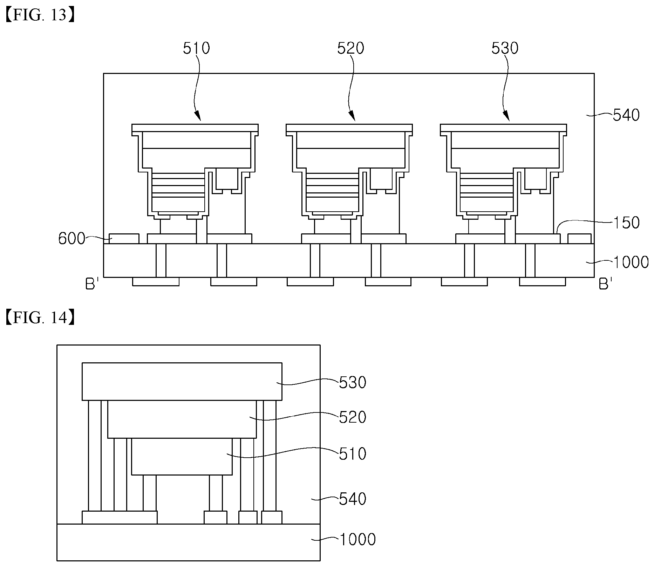

FIG. 12 is a schematic sectional view of a light emitting module according to a second embodiment of the present invention, to which light emitting devices according to the present invention are applied, and FIG. 13 is a schematic cross-sectional view of the light emitting module taken along B-B' in FIG. 12.

Referring to FIG. 12 and FIG. 13, the light emitting module according to the second embodiment is different from the light emitting module according to the first embodiment in that a light reflective layer 600 is further disposed on an upper surface of a module substrate 1000. Description of the same configuration as the first embodiment will be omitted herein.

The light reflective layer 600 may have a reflectivity of 80% or more with respect to light emitted from the light emitting devices 510, 520, 530.

Referring to FIG. 12, in top view, an opening is formed inside the light reflective layer 600 and the light emitting devices 510, 520, 530 are disposed inside the opening such that the light reflective layer 600 surrounds outer surfaces of the light emitting devices 510, 520, 530.

Referring to FIG. 12, in side view, the light reflective layer 600 extends from the opening, in which the light emitting devices 510, 520, 530 are disposed, along an upper surface of the module substrate 1000. The light reflective layer 600 may have a similar thickness to or a different thickness than the electrode pads 150, without being limited thereto.

In addition, a side surface of the light reflective layer 600 may be covered by the molding portion 540. Accordingly, the molding portion 540 further flattens the surface of the light reflective layer 600 by preventing the light reflective layer 600 from being peeled off of the module substrate 1000, thereby improving a light reflection effect.

The light reflective layer 600 may extend to a region between the light emitting devices 510, 520, 530. The light reflective layer 600 may be formed of a metallic material or may be formed of an insulating material. For example, the metallic material may include one of Al, Au, Au, Ni, Ti, and the like, and the insulating material may be silicone, polyimide, or the like.

The light emitting devices according to the present invention may be independently driven or controlled, and the light emitting module may be provided with an integrated circuit (IC) or an IC driver. The IC or the IC driver may be electrically connected to the multiple light emitting devices and may be covered together with the multiple light emitting devices by a molding layer. Accordingly, since the IC or the IC driver can be handled together with the multiple light emitting devices, the light emitting module can be easily applied to products. A height from an upper surface of the IC or the IC driver to a light emitting surface of the molding layer may be different from a height from upper surfaces of the light emitting devices to the light emitting surface of the molding layer. However, the molding layer can compensate for such a height difference such that the light emitting surface is in the same location.

FIG. 14 is a schematic sectional view of a light emitting module according to a third embodiment of the present invention, to which light emitting devices according to the present invention are applied. Referring to FIG. 14, the light emitting module according to the third embodiment includes multiple light emitting devices 510, 520, 530 stacked in the vertical direction, unlike the light emitting modules according to the first and second embodiments, in which the multiple light emitting devices 510, 520, 530 are arranged parallel to each other in the horizontal direction.

Referring to FIG. 14, although the second light emitting device 520 is disposed on the first light emitting device 510 and the third light emitting device 530 is disposed on the second light emitting device 520, it should be understood that the present invention is not limited to this stacking sequence and the stacking sequence may be changed, as needed.

In addition, although FIG. 14 shows that the first light emitting device 510 disposed at the lowermost side has the narrowest width and the widths of the second light emitting device 520 and the third light emitting device 530 gradually increase in the upward direction, it should be understood that the present invention is not limited thereto. By way of example, the first to third light emitting devices 510, 520, 530 may have the same width or may have different widths, as needed. Description of the same configuration as the first embodiment will be omitted herein.

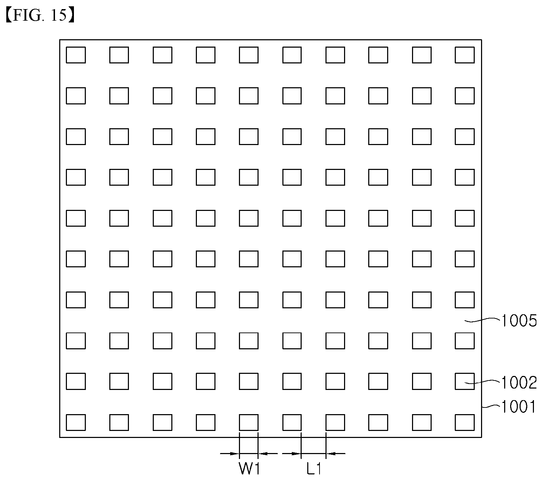

FIG. 15 is a top view of one example of a display panel, to which light emitting devices according to yet another embodiment of the present invention are applied. The display panel may be applied to signage or displays, vehicles, and the like.

The display panel includes a circuit board 1001, pixels 1002, and a buffer material layer 1005.

The circuit board 1001 or a panel substrate may include circuits for passive matrix driving or active matrix driving. In one embodiment, the circuit board 1001 may include interconnects and resistors therein. In another embodiment, the circuit board 1001 may include interconnects, transistors, and capacitors. The circuit board 1001 may include pads 1003 disposed on an upper surface thereof to allow electrical connection to the circuits formed therein.

Multiple pixels 1002 are aligned on the circuit board 1001. The pixels 1002 may be micro-light emitting devices and may have a width W1 of 1,000 µm or less. In one embodiment, a distance L1 between the pixels 1002 may be greater than the width W1 of the pixels 1002 in an alignment direction of the pixels 1002. In another embodiment, for pixel adjustment, the distance L1 between the pixels 1002 may be smaller than the width W1 of the pixels 1002 in the alignment direction of the pixels 1002. Each of the pixels 1002 includes multiple light emitting devices. For example, each of the pixels 1002 may include blue, green and red sub-pixels.

The buffer material layer 1005 may cover regions of the circuit board 1001 between the pixels 1002 while covering upper surfaces of the pixels 1002. The buffer material layer 1005 may also include a matrix that is transparent to light, without being limited thereto. For example, the buffer material layer 1005 serves to reflect or absorb light. To this end, the buffer material layer 1005 may include a matrix having light reflection characteristics or a matrix having light absorption characteristics. Alternatively, the buffer material layer 1005 may contain a light absorption material, such as carbon black, or a light scattering material, such as silica, in a matrix thereof.

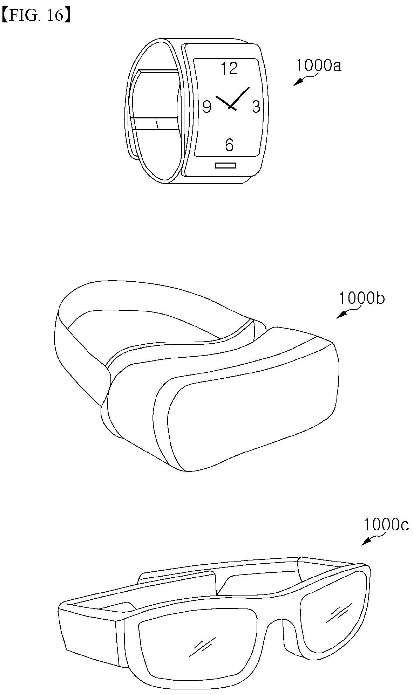

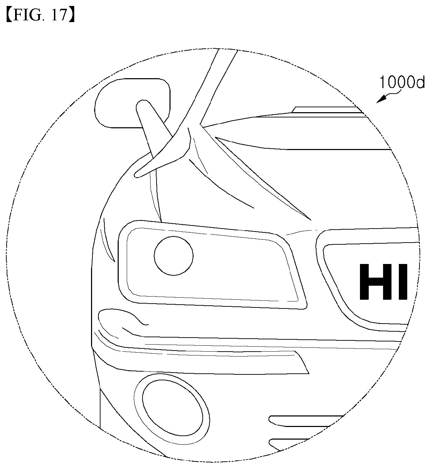

FIG. 16 is a schematic view of a smart watch, a VR headset, and augmented reality glasses, to which light emitting devices according to the present invention are applied, and FIG. 17 is a schematic view of a vehicle to which light emitting devices according to the present invention are applied.

Referring to FIG. 16 and FIG. 17, the light emitting devices according to the present invention may be applied to a VR display apparatus, such as a smart watch 1000a and a VR headset 1000b, an AR display apparatus, such as augmented reality glasses 1000c, or a display apparatus, such as a sign and the like. Alternatively, the light emitting devices according to the present invention may be applied to a display of a vehicle 1000d to implement icons, such as character strings (English, numbers, Korean, and the like) or pictures. The display apparatus may be networked with an external source to implement user-specified characters or icons. The external source may be an application, an on-board system configuration in a vehicle, or the like.

The light emitting module according to the present invention may have a luminance of 4 cd to 60 cd and may be suitably applied to a rear lamp of an automobile.

In addition, the multiple light emitting modules according to the present invention may have the same size and the same electrode pads may be applied to the multiple light emitting modules. As such, as the multiple light emitting modules according to the present invention have the same size and the same electrode pad is applied to the multiple light emitting modules, the light emitting modules according to various embodiments of the present invention may be freely selected and arranged as desired by a user.

The multiple light emitting diodes in the light emitting module according to the present invention may be individually controllable.

The present invention provides a system to which the light emitting module is applied.

The system according to the present invention may be a display system that is turned on while the speed of a means provided with the light emitting module is controlled to decrease.

The system according to the present invention may be a display system that includes multiple light emitting modules disposed in each section of a displaceable means, wherein at least one of the light emitting modules is selectively turned on by a user so as to be perceived externally.

The system according to the present invention may be a display system that implements character strings (English, numbers, Korean, and the like) or images.

The present invention may be implemented through a subscription service. By way of example, an internal display and/or an external display of a means provided with the light emitting module may be designed to allow implementation of a service, such as a particular color, a particular character, a particular shape, or the like, thereon when a user subscribes to the service. The system according to the present invention may be designed to allow implementation of change in colors of automobile interior lamps, implementation of a certain string of characters on an automobile exterior display, and the like through a subscription service.

In addition, the subscription service may proceed through an intermediate medium, such as Internet sites, applications of mobile phones, and the like. By way of example, the subscription service may proceed through the following stages: 1) selection of options by a user through the intermediate media, 2) payment by the user for the selected options, and 3) provision of the service by a product provider by driving the light emitting module. The product provider may send signals online to drive the light emitting module or to drive the light emitting module directly offline depending on an option selected by the user.

The light emitting device according to the present invention may be applied to a module for plant lighting to assist in growth of plants. The module for plant lighting includes a circuit board and multiple light emitting devices 510, 520, 530 mounted on the circuit board. The multiple light emitting devices may be any one of the light emitting devices according to the above embodiments.

Although the specification shows that the side surface of the mesa M is formed vertically, the light emitting device according to the present invention may be formed to have a mesa having an at least partially inclined side surface.

Although some embodiments have been described herein with reference to the accompanying drawings, it should be understood that various modifications and changes can be made by those skilled in the art or by a person having ordinary knowledge in the art without departing from the spirit and scope of the present invention defined by the claims and equivalents thereto.

Therefore, the scope of the present invention should be defined by the appended claims and equivalents thereto rather than by the detailed description of the invention.

## Claims

1. A light emitting device comprising:
a first window layer supplying electrons;
a second window layer supplying holes;
an active layer interposed between the first window layer and the second window layer;
an electron regulation layer interposed between the first window layer and the active layer;
a hole regulation layer interposed between the second window layer and the active layer; and
an intermediate layer interposed between the second window layer and the hole regulation layer,
wherein the intermediate layer has different roughnesses on upper and lower interfaces thereof.

2. The light emitting device according to claim 1, wherein the intermediate layer comprises an uneven interface.

3. The light emitting device according to claim 1, wherein the intermediate layer comprises Al and In and has a greater In-concentration gradient than an Al-concentration gradient per unit distance.

4. The light emitting device according to claim 1, wherein the intermediate layer comprises a Group III material contained in a layer disposed on the intermediate layer and a Group III material contained in a layer disposed under the intermediate layer.

5. The light emitting device according to claim 1, wherein the intermediate layer has different distributions or densities of Al and In per unit region thereof.

6. The light emitting device according to claim 1, wherein the intermediate layer has a smaller thickness than a layer disposed on the intermediate layer and a layer disposed under the intermediate layer.

7. The light emitting device according to claim 6, wherein the layer disposed on the intermediate layer, the layer disposed under the intermediate layer, and the intermediate layer have thicknesses decreasing in the stated sequence.

8. The light emitting device according to claim 1, wherein the intermediate layer has a continuous shape.

9. The light emitting device according to claim 8, wherein the intermediate layer has a thickness of greater than 10 nm to 400 nm.

10. The light emitting device according to claim 1, wherein the intermediate layer has a discontinuous shape.

11. The light emitting device according to claim 10, wherein the intermediate layer has a thickness of 10 nm or less.

12. The light emitting device according to claim 1, wherein an upper interface of the second window layer is an uneven surface.

13. The light emitting device according to claim 12, wherein a lower interface of the first window layer is a textured surface and has a different shape or roughness than the upper interface of the second window layer.

14. The light emitting device according to claim 1, further comprising:
a first cladding layer interposed between the first window layer and the electron regulation layer.

15. The light emitting device according to claim 1, further comprising:
a second cladding layer interposed between the hole regulation layer and the intermediate layer.

16. A light emitting module comprising:
the light emitting device according to any one of claims 1 to 15;
an electrode pad electrically connected to the light emitting device; and
a module substrate on which the electrode pad is disposed.

17. The light emitting module according to claim 16, further comprising:
a light reflective layer reflecting at least some fraction of light emitted from the light emitting device.

18. The light emitting module according to claim 16, wherein multiple light emitting devices are arranged parallel to each other in a horizontal direction.

19. The light emitting module according to claim 16, wherein multiple light emitting devices are stacked in a vertical direction.

20. The light emitting module according to claim 19, wherein the multiple light emitting devices have widths gradually increasing in an upward direction.
